# FASCICULE DE BREVET EUROPEEN

(11) **EP 2 836 473 B1**
(45) Date de publication et mention de la délivrance du brevet: **02.11.2016**
(21) Numéro de dépôt: 13720477.2
(22) Date de dépôt: 11.04.2013
(51) Int. Cl.: C04B 35/80, C04B 41/91, C23C 16/02, C04B 35/622

(54) **PROCEDE DE TRAITEMENT DE FIBRES DE CARBURE DE SILICIUM.**
VERFAHREN ZUR BEHANDLUNG VON FASERN AUS SILIZIUMCARBID
PROCESS FOR THE TREATMENT OF SILICON CARBIDE FIBRES

(30) Priorité: 13.04.2012 FR 1253426
(43) Date de publication de la demande: 18.02.2015
(73) Titulaire: HERAKLES, 33185 Le Haillan (FR)
(72) Inventeur: LOISON, Sylvie, F-33160 Saint Medard En Jalles (FR); LAQUET, Jean Luc, F-33700 Merignac (FR); ROCHER, Jean Philippe, F-33185 Le Haillan (FR)
(74) Mandataire: Mendelsohn, Isabelle M. N.
(86) Numéro de dépôt international: PCT/FR2013/050788
(87) Numéro de publication internationale: WO 2013/153336

(56) Documents cités:
- EP-A1- 0 855 373

## Description

La présente invention concerne les fibres en carbure de silicium (SiC), utilisés comme renfort dans la fabrication de matériaux composites.

La recherche de bonnes propriétés mécaniques des matériaux composites, en particulier aux températures élevées, a conduit à utiliser des matériaux céramiques pour le renfort fibreux, à la place du carbone qui montre une résistance mécanique limitée et une résistance à l'oxydation insuffisante en cas de séjour prolongé en milieu oxydant à haute température.
D'une façon générale, il est bien connu que dans les matériaux composites à renfort fibreux, les caractéristiques de l'interface fibres-matrice ont une grande influence sur les propriétés mécaniques du matériau.
Dans le cas de matériaux composites à matrice céramique, il a été montré qu'un comportement satisfaisant peut être obtenu, en particulier vis-à-vis des chocs et de la propagation des fissures, et en dépit du caractère céramique de la matrice, en formant sur les fibres un revêtement intermédiaire de faible épaisseur par exemple en carbone pyrolytique déposé en phase vapeur ou en nitrure de bore, avant infiltration du matériau céramique de la matrice. Un tel procédé est décrit dans le brevet français FR 2 567 874).
Toutefois il est intéressant d'améliorer l'interface de liaison entre la couche de carbone pyrolytique ou de nitrure de bore déposée et les fibres en carbure de silicium. Il est également intéressant de pouvoir disposer de fibres en carbure de silicium ayant des propriétés mécaniques renforcées.
Il est déjà connu que la formation d'une couche superficielle de carbone microporeux à la surface de fibres en carbure de silicium présente des avantages en termes d'amélioration des propriétés mécaniques à température ambiante (US6579833, WO2005/007566) et constitue en outre une bonne interface de liaison avec la couche de carbone pyrolytique déposée (WO 2010/076475).

Toutefois le procédé décrit dans ces documents met en oeuvre un traitement thermique réactif à base de gaz halogéné générant une couche de carbone microporeux à la surface du carbure. Ce procédé est donc compliqué à mettre en oeuvre tant du point de vue du procédé en lui-même que des moyens pour sa mise en oeuvre qui doivent être résistants aux halogènes.
En outre certaines fibres en carbure de silicium possèdent à leur surface une mince couche de silice qu'il convient d'éliminer avant tout traitement ultérieur.
Il est connu d'après la demande de brevet FR2640258, un traitement d'élimination par voie chimique de la silice présente à la surface des fibres en carbure de silicium. Toutefois, le traitement préconisé qui consiste en l'utilisation
soit d'acide fluorhydrique en solution dans l'eau,
soit d'une solution d'acide nitrique dans l'eau à chaud,
soit encore d'un mélange d'acides fluorhydrique, nitrique et acétique dans les proportions précises (HF 3 ml + HNO₃ 5 ml + CH3 - CO₂H 3 ml) à chaud, ce qui corresponds à un ratio molaire HF/HNO₃ de 1,29,
ne permet pas l'élimination totale de la couche de silice présente à la surface des fibres : la couche est uniquement réduite à une épaisseur de l'ordre de 0,005 microns, ce qui correspond à la limite de détection.
Il serait donc intéressant de pouvoir disposer d'un procédé qui permette à la fois l'élimination totale de la couche de silice présente à la surface des fibres et la formation d'une couche superficielle de carbone microporeux.
Il est connu également d'après la demande de brevet EP0855373 d'utiliser de l'acide fluorhydrique ou un mélange d'acide fluorhydrique et d'acide nitrique en tant que solution de lavage des fibres SiC lors de leur fabrication. Toutefois, cette étape de lavage n'est pas une étape de traitement chimique puisqu'elle ne sert qu'à éliminer les résidus des produits initiaux n'ayant pas réagi présents à la surface des fibres après leur fabrication, tels que des particules de dioxyde de silicium (ou silice). Elle ne permet donc pas la formation d'une couche de carbone microporeux sur ces fibres. En outre ce document ne divulgue qu'une solution aqueuse contenant 46% en poids d'HF mélangé à une teneur équivalente d'une solution de HNO₃ contenant de 60 à 70% en poids de HNO₃. L'exemple 2 divulgue ainsi un mélange de 250ml de la solution aqueuse d'HF avec 250 ml de la solution de HNO₃. Ainsi donc la solution acide de cet exemple présente une teneur en acide nitrique comprise entre 4,76 et 5,54 mol/L et une teneur en HF d'environ 11,5mol/L, c'est-à-dire un ratio molaire acide fluorhydrique sur acide nitrique compris entre 2,08 et 2,41. Les concentrations en acide décrites dans ce document sont donc tellement fortes qu'il est impossible de contrôler la réaction.

Les inventeurs ont donc découvert de façon surprenante que l'utilisation combinée d'acide fluorhydrique et d'acide nitrique, en solution aqueuse, sans ajout d'acide acétique, permettait de supprimer totalement la couche de silice présente à la surface des fibres en carbure de silicium tout en permettant la formation d'une couche de carbone microporeux par exemple ≤100 nm adhérant aux fibres et ayant une épaisseur homogène. Cette utilisation ne peut être assimilé à l'étape de lavage selon la demande de brevet EP0855373, puisqu'elle n'a pas lieu au cours de la fabrication des fibres et qu'il n'est pas nécessaire d'éliminer les produits initiaux n'ayant pas réagi présents à la surface de ces fibres.
Par ailleurs cette couche de carbone microporeux constitue une bonne interface de liaison pour le dépôt d'une couche de carbone pyrolytique.
En effet, dans cette couche, le carbone ne présente pas d'organisation structurale particulière. Il est microporeux et présente des surfaces spécifiques très élevées (de l'ordre de 1500 m²/g) associées à des pores de très petites tailles (diamètre des pores de l'ordre du nanomètre). En outre si une couche de carbone pyrolytique est déposée sur cette couche de carbone microporeux, les deux couches forment une interphase mixte de carbone qui permet d'accroître les caractéristiques mécaniques du matériau composite notamment en ce qui concerne la contrainte et la déformation à la rupture.

La présente invention concerne donc un procédé de traitement de fibres en carbure de silicium comprenant l'étape de traitement chimique des fibres avec une solution aqueuse d'acide contenant de l'acide fluorhydrique et de l'acide nitrique afin d'éliminer la silice présente à la surface des fibres et de former une couche de carbone microporeux, caractérisé en ce que ladite solution aqueuse d'acide ne contient pas d'acide acétique.
Ainsi donc les inventeurs ont découvert que l'utilisation combinée d'acide fluorhydrique et d'acide nitrique en solution aqueuse était plus avantageuse que l'utilisation seule de chacun de ces acides et que leur utilisation combinée avec de l'acide acétique puisqu'elle permettait d'éliminer totalement la silice présente à la surface des fibres et de former une couche de carbone microporeux inférieur ou égale à 100 nm. Il y a donc une synergie dans l'utilisation combinée d'HF et de HNO₃ qui n'était pas du tout suggérée dans l'art antérieur. En effet HF élimine la silice présente à la surface des fibres et HNO₃ rend soluble la silice et oxyde le carbure et l'oxycarbure de silicium de la fibre pour permettre la création de la couche de carbone microporeux. Si HF est utilisée seul, toute la silice peut ne pas être éliminée si sa forme chimique n'est pas soluble et aucune couche de carbone microporeux n'est présente à la surface des fibres. Si en revanche HNO₃ est utilisée seul, il n'y aura aucune élimination de la silice et donc l'oxydation ne pourra pas avoir lieu ni la création de la couche de carbone microporeux. L'utilisation combinée de ces deux acides est donc primordiale pour réaliser l'invention. En outre, il a été découvert de façon surprenante que contrairement à ce qui était suggéré dans l'art antérieur, l'acide acétique n'a pas d'impact sur la silice recouvrant les fibres et que la présence de cet acide dans la solution aqueuse acide lors de l'étape de traitement chimique est donc inutile.
Avantageusement ce procédé n'est pas mis en oeuvre lors du procédé de fabrication des fibres ou en tant qu'étape de lavage de ce procédé, c'est-à-dire sur des fibres présentant sur leur surface des produits initiaux qui n'ont pas réagi, tels que par exemple des particules de dioxyde de silicium. Le procédé selon l'invention ne sert donc pas de simple étape de lavage des fibres, mais permet la formation d'une couche de carbone microporeux à la surface des fibres.

Le ratio d'acide utilisable dans le cadre de la présente invention dépend de la l'épaisseur de la couche de carbone microporeux voulue, du type de fibres sur lesquels le traitement est appliqué (rapport carbure sur oxycarbures et des types de carbures) et de la température du traitement. Dans un mode de réalisation particulier de la présente invention, en particulier à une température de 20°C, la solution aqueuse d'acide selon l'invention contient un ratio molaire acide fluorhydrique /acide nitrique inférieur à 1,5, avantageusement inférieur à 1,2, encore plus avantageusement inférieur à 1, de façon encore plus avantageuse inférieur à 0,8, en particulier supérieur à 0,1, avantageusement supérieur à 0,15, encore plus avantageusement supérieur à 0,2.
D'une manière générale, il est avantageux que les solutions acides ne soient pas trop concentrées pour pouvoir gérer une cinétique d'attaque contrôlable et donc une bonne reproductibilité de la couche de carbone formée.
De façon avantageuse, la solution aqueuse d'acide selon l'invention contient à 20°C une teneur en acide nitrique comprise entre 0,5 et 5 mol/l, avantageusement entre 2 et 5 mol/l, en particulier entre 0,5 et 4 mol/l, particulièrement entre 2 et 4 mol/l.
En effet au-delà de 5 mol/l, il y a un risque que les molécules de HNO₃ bloquent stériquement l'accès de HF à la surface des fibres ce qui pourrait aller jusqu'à empêcher la réaction d'avoir lieu. En revanche, il est nécessaire pour amorcer la réaction d'avoir un minimum d'HNO₃ présent.
La solution aqueuse d'acide selon l'invention contient à 20°C une teneur en acide fluorhydrique comprise entre 0,5 et 4 mol/l, avantageusement entre 0,5 et 3 mol/l, en particulier entre 0,5 et 2,5 mol/l, plus particulièrement entre 0,5 et 2 mol/l.
La quantité d'HF détermine la cinétique de réaction pour une concentration de HNO₃ donnée.
Dans un autre mode de réalisation particulier de la présente invention, l'étape de traitement chimique est mise en oeuvre à température ambiante, c'est-à-dire entre 20 et 25°C. Elle n'est donc pas mise en oeuvre à chaud contrairement à ce qui est préconisé dans la demande de brevet FR2640258 19.05.2015 lorsque l'acide nitrique est présent. La durée de l'étape de traitement chimique dépend de l'épaisseur de la couche de carbone microporeux que l'on souhaite obtenir à la surface de la fibre et du ratio HF/ HNO₃ utilisé. Avantageusement cette étape dure entre 10 minutes et 5 heures, avantageusement entre 3 et 5 heures pour obtenir une couche inférieure ou égale à 100 nm.

Dans encore un autre mode de réalisation de la présente invention, l'étape de traitement chimique est mise en oeuvre à chaud, c'est-à-dire à une température supérieure à la température ambiante, en particulier à environ 30°C. La durée de l'étape de traitement chimique peut dans ce cas être plus faible qu'à température ambiante. Dans le cas où la température du traitement chimique est d'environ 30°C, cette étape dure entre 10 minutes et 3 heures, avantageusement entre 10 minutes et 2 heures pour obtenir une couche inférieure ou égale à 100 nm.

Dans encore un autre mode de réalisation de la présente invention l'étape de traitement chimique est mise en oeuvre à froid, c'est-à-dire à une température inférieure à la température ambiante, en particulier à environ 10°C. Dans le cas où la température du traitement chimique est d'environ 30°C, cette étape dure entre 2 heures et 8 heures, avantageusement entre 2 heures et 6 heures pour obtenir une couche inférieure ou égale à 100 nm.

En particulier, le traitement chimique selon la présente invention est mis en oeuvre en plongeant les fibres dans une solution aqueuse d'acide selon la présente invention pendant le temps nécessaire à la suppression de la couche de silice superficielle et à la formation de la couche de carbone microporeux. Avantageusement la solution aqueuse acide selon l'invention contient uniquement de l'eau et les acides HF et HNO₃. Après ce traitement, le procédé selon la présente invention peut comprendre une étape de rinçage à l'eau et de séchage des fibres traitées obtenues. Ceci permet d'éliminer toute trace résiduelle de solution acide utilisée dans le procédé selon la présente invention.

Avantageusement, les fibres de carbure de silicium obtenues suite au traitement selon la présente invention ont une couche superficielle de carbone microporeux ≤100 nm, de façon avantageuse d'environ 50 nm. Encore plus avantageusement, la couche de silice superficielle présente sur les fibres non traitées a disparue. En effet, avant traitement les fibres sont recouvertes de silice sur une épaisseur variable, dont la moyenne est d'environ égale à 0,3 microns. Grâce au traitement selon la présente invention, cette couche a totalement disparu.

Les fibres traitées par le procédé selon la présente invention peuvent avoir n'importent quelle forme par exemple fils, mèches, torons, câbles, tissus, feutres, tresses, mats et même préforme bi ou tridimensionnel. Il s'agit en particulier de fibres Nicalon® disponibles commercialement auprès de la société NIPPON CARBON Co. Il peut également s'agir de fibres Tyranno ® de UBE Industries.

Dans un mode supplémentaire de réalisation de la présente invention, les fibres à traiter sont recouvertes d'un ensimage non éliminable par le traitement chimique et le procédé selon la présente invention comprend l'étape préalable d'élimination quasi complète dudit ensimage, avantageusement par traitement thermique. En effet, alors que la solution aqueuse acide selon l'invention provoque une dissolution partielle d'un ensimage à base d'alcool polyvinylique, il est sans effet sur l'ensimage vinylacétate qui peut également recouvrir certaines fibres de carbure de silicium. Dans ce dernier cas, et pour que le traitement ultérieur par la solution aqueuse d'acide selon l'invention puisse être totalement efficace, il est donc préférable d'éliminer au préalable l'ensimage vinylacétate. Pour ce faire, on peut soumettre les fibres SiC à un traitement de désensimage thermique (cette technique étant plus efficace qu'un désensimage chimique, également utilisable). Les fibres SiC sont par exemple portées à une température de 600°C dans l'air pendant 20 secondes. L'utilisation d'une température relativement modérée pendant un laps de temps très court évite une oxydation notable du carbure de silicium.
Avantageusement les fibres à traiter par le procédé selon la présente invention ne présentent pas sur leur surface de résidus des produits initiaux ayant servi à leur fabrication, tels que par exemple des particules de dioxyde de silice.

Dans un autre mode de réalisation de la présente invention, le procédé selon l'invention comprend l'étape supplémentaire de dépôt d'une couche de carbone pyrolytique sur les fibres en carbure de silicium traitées par le procédé selon la présente invention. Ce dépôt peut être réalisé par des techniques bien connues de l'homme du métier, par exemple tel que décrites dans la demande de brevet FR2 567 874. Ce dépôt a donc lieu directement sur la couche de carbone microporeux.

La présente invention concerne en outre un procédé de fabrication d'une préforme fibreuse comprenant la formation d'une structure fibreuse à base de fibres en carbure de silicium, les fibres ayant été traitées conformément au procédé de traitement selon la présente invention.
La mise en forme de la préforme peut être réalisée par bobinage, tissage, empilage, et éventuellement aiguilletage de strates bidimensionnelles de tissu ou de nappes de câbles contenant les fibres de carbure de silicium...

Dans un premier mode de réalisation avantageux, les fibres sont traitées avant la formation de la structure fibreuse. Ainsi, après le traitement des fibres selon la présente invention, les fibres sont utilisées pour la réalisation d'une préforme fibreuse de pièces en matériaux composites.

Dans un deuxième mode de réalisation avantageux, les fibres sont traitées après la formation de la structure fibreuse.

Ainsi par exemple dans ce dernier cas, c'est la structure fibreuse qui est directement plongée dans le bain contenant la solution aqueuse acide selon la présente invention.

La présente invention concerne enfin un procédé de fabrication d'une pièce en matériau composite comprenant la réalisation d'une préforme fibreuse conformément au procédé selon l'invention et la densification de ladite préforme.

La fabrication de pièces en matériau composite renforcé par des fibres en carbure de silicium est bien connue. Elle comprend généralement la réalisation d'une préformée fibreuse céramique dont la forme est voisine de celle de la pièce à fabriquer et la densification de la préforme par une matrice. La préforme fibreuse constitue le renfort de la pièce dont le rôle est essentiel vis-à-vis des propriétés mécaniques.
La densification du renfort fibreux peut-être réalisé par voie liquide (imprégnation par une résine précurseur de la matrice et transformation par réticulation et pyrolyse, le processus pouvant être répété) ou par voie gazeuse (infiltration chimique en phase vapeur de la matrice). L'invention s'applique notamment à la réalisation de pièces en matériau composite à matrice au moins en partie céramique, et avantageusement à matrice totalement céramique (CMC), formées par un renfort fibreux en fibres de carbure de silicium densifié par une matrice au moins en partie céramique ou totalement céramique, notamment carbure, nitrure, oxydes réfractaires, etc. Des exemples typiques de tels matériaux CMC à fibres en carbure de silicium sont les matériaux SiC-SiC (renfort en fibres de carbure de silicium et matrice en carbure de silicium).

L'invention sera mieux comprise à la lumière des figures et des exemples qui suivent.
La figure 1 représente la concentration atomique en silicium, carbone, azote et oxygène (en %) en fonction de la profondeur (en nm) à l'intérieur de la fibre avant traitement (zéro correspond à la surface de la fibre).
La figure 2 représente la concentration atomique en silicium, carbone, azote et oxygène (en %) en fonction de l'épaisseur de la fibre après traitement selon l'invention (zéro correspond à la surface de la fibre).

### Exemple 1

Le procédé conforme à l'invention a été mis en oeuvre sur des textures fibreuses, et plus particulièrement des tissus formés de fibres SiC produites par la société japonaise NIPPON CARBON Co. Ltd en utilisant un traitement d'élimination de la silice et de formation d'une couche de carbone microporeuse par trempage des textures dans un bain contenant une solution aqueuse d'acide fluorhydrique (0,7 mol/l) et d'acide nitrique (3 mol/l) pendant 4 heures à température ambiante.
Les textures fibreuses obtenues sont ensuite rincées à l'eau et séchée. Avant ce traitement, un désensimage des textures fibreuses est effectué par voie thermique. Les fibres SiC sont portées à une température de 600°C dans l'air pendant 20 secondes.

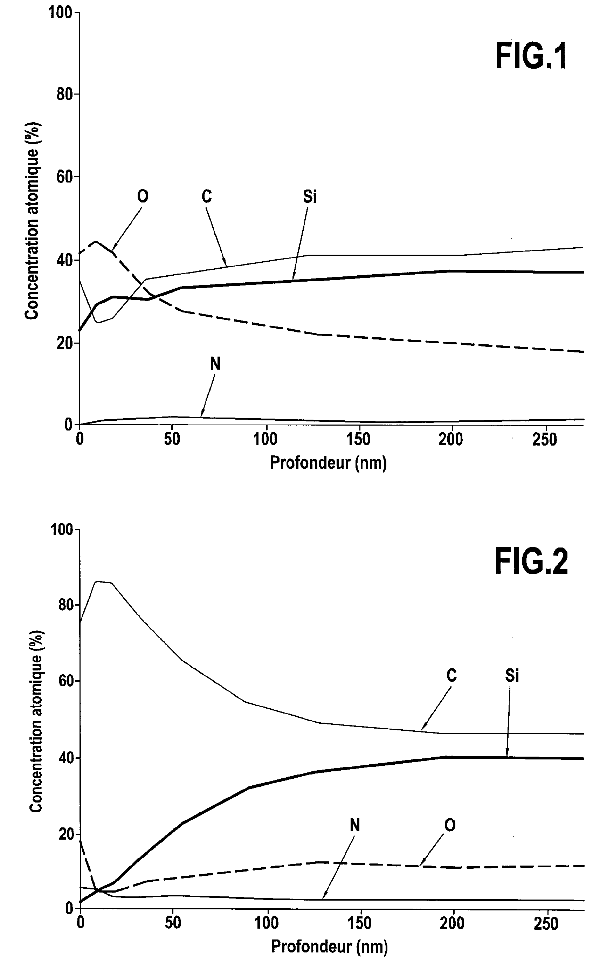

En comparant les figures 1 et figure 2 ci-jointes, il est à remarquer que la silice a disparu de la surface des fibres traitées par le procédé selon l'invention et a été remplacé par une couche de carbone microporeux.

### Exemple 2 comparatif

Le procédé conforme à la demande de brevet FR2640258 a été mis en oeuvre sur des textures fibreuses, et plus particulièrement des tissus formés de fibres SiC produites par la société japonaise NIPPON CARBON Co. Ltd en utilisant un traitement d'élimination de la silice par trempage des textures dans un bain contenant une solution aqueuse d'acide fluorhydrique (à une concentration comprise entre environ 20 et 30 % molaire) pendant environ 1 heure à température ambiante.

Les textures fibreuses obtenues sont ensuite rincées à l'eau et séchée. Avant ce traitement, un désensimage des textures fibreuses est effectué par voie thermique, par exemple à 600 °C sous air pendant 20 secondes.

Les fibres avant traitement sont recouvertes de silice sur une épaisseur de moyenne d'environ 0,3 microns. Après ce traitement cette épaisseur est réduite à environ 0,005 microns et aucune trace de carbone microporeux n'est présent à la surface des fibres.

### Exemple 3

On met en oeuvre le même procédé que dans l'exemple 1 à l'exception du fait que le bain contient une solution aqueuse d'acide fluorhydrique à 2,3 mol/l et d'acide nitrique à 4 mol/l, que la durée de traitement est de 75 minutes et que la température de traitement est de 30°C.

L'épaisseur de la couche de carbone microporeux obtenue à la surface des fibres est de 215 nm.

### Exemple 4

On met en oeuvre le même procédé que dans l'exemple 1 à l'exception du fait que la durée de traitement est de 30 minutes et que la température de traitement est de 30°C.

L'épaisseur de la couche de carbone microporeux obtenue à la surface des fibres est de 30nm.

### Exemple 5

On met en oeuvre le même procédé que dans l'exemple 1 à l'exception du fait que la durée de traitement est de 120 minutes et que la température de traitement est de 30°C.

L'épaisseur de la couche de carbone microporeux obtenue à la surface des fibres est de 100-90nm.

### Exemple 6

On met en oeuvre le même procédé que dans l'exemple 1 à l'exception du fait que la durée de traitement est de 480 minutes et que la température de traitement est de 10°C.

L'épaisseur de la couche de carbone microporeux obtenue à la surface des fibres est au maximum de 70nm.

## Revendications

1. Procédé de traitement de fibres en carbure de silicium comprenant l'étape de traitement chimique des fibres avec une solution aqueuse d'acide contenant de l'acide fluorhydrique et de l'acide nitrique afin d'éliminer la silice présente à la surface des fibres et de former une couche de carbone microporeux, **caractérisé en ce que** ladite solution aqueuse d'acide ne contient pas d'acide acétique et **en ce que** sa teneur en acide fluorhydrique est comprise entre 0,5 et 4 mol/l.

2. Procédé selon la revendication 1, **caractérisé en ce que** la solution aqueuse d'acide contient un ratio molaire acide fluorhydrique /acide nitrique inférieur à 1,5, avantageusement inférieur à 0,7, en particulier supérieur à 0,1.

3. Procédé selon l'une quelconque des revendications 1 ou 2, **caractérisé en ce que** la solution aqueuse d'acide contient une teneur en acide fluorhydrique comprise entre 0,5 et 2 mol/l.

4. Procédé selon l'une quelconque des revendications 1 à 3, **caractérisé en ce que** la solution aqueuse d'acide contient une teneur en acide nitrique comprise entre 0,5 et 5 mol/l, avantageusement entre 2 et 5 mol/l.

5. Procédé selon l'une quelconque des revendications 1 à 4, **caractérisé en ce que** l'étape de traitement chimique est mise en oeuvre à température ambiante et dure 4 heures.

6. Procédé selon l'une quelconque des revendications 1 à 5, **caractérisé en ce que** les fibres obtenues ont une couche superficielle de carbone microporeux ≤100 nm.

7. Procédé selon l'une quelconque des revendications 1 à 6, **caractérisé en ce que** les fibres sont recouvertes d'un ensimage non éliminable par le traitement chimique et **en ce que** le procédé comprend l'étape préalable d'élimination quasi complète dudit ensimage par traitement thermique.

8. Procédé selon l'une quelconque des revendications 1 à 7, **caractérisé en ce qu'**il comprend l'étape supplémentaire de dépôt d'une couche de carbone pyrolytique sur les fibres en carbure de silicium traitées.

9. Procédé de fabrication d'une préforme fibreuse comprenant la formation d'une structure fibreuse à base de fibres en carbure de silicium, **caractérisé en ce que** les fibres ont été traitées conformément au procédé de traitement selon l'une quelconque des revendications 1 à 8.

10. Procédé selon la revendication 9, **caractérisé en ce que** les fibres sont traitées avant la formation de la structure fibreuse.

11. Procédé selon la revendication 9, **caractérisé en ce que** les fibres sont traitées après la formation de la structure fibreuse.

12. Procédé de fabrication d'une pièce en matériau composite comprenant la réalisation d'une préforme fibreuse conformément au procédé selon l'une quelconque des revendications 9 à 11 et la densification de ladite préforme.

## Patentansprüche

1. Verfahren zur Behandlung von Siliziumkarbidfasern, umfassend den Schritt der chemischen Behandlung der Fasern mit einer wässrigen Säurelösung, die Flusssäure und Salpetersäure enthält, um das an der Oberfläche der Fasern vorhandene Siliziumdioxid zu entfernen und um eine Schicht aus mikroporösem Kohlenstoff zu bilden, **dadurch gekennzeichnet, dass** die wässrige Säurelösung keine Essigsäure enthält und dass ihr Gehalt an Flusssäure zwischen 0,5 und 4 mol/l beträgt.

2. Verfahren nach Anspruch 1, **dadurch gekennzeichnet, dass** die wässrige Säurelösung ein Molverhältnis Flusssäure/Salpetersäure kleiner als 1,5, vorteilhafterweise kleiner als 0,7, insbesondere größer als 0,1 enthält.

3. Verfahren nach einem der Ansprüche 1 oder 2, **dadurch gekennzeichnet, dass** die wässrige Säurelösung einen Flusssäuregehalt zwischen 0,5 und 2 mol/l enthält.

4. Verfahren nach einem der Ansprüche 1 bis 3, **dadurch gekennzeichnet, dass** die wässrige Säurelösung einen Salpetersäuregehalt zwischen 0,5 und 5 mol/l, vorteilhafterweise zwischen 2 und 5 mol/l enthält.

5. Verfahren nach einem der Ansprüche 1 bis 4, **dadurch gekennzeichnet, dass** der Schritt der chemischen Behandlung bei Raumtemperatur durchgeführt wird und 4 Stunden dauert.

6. Verfahren nach einem der Ansprüche 1 bis 5, **dadurch gekennzeichnet, dass** die erhaltenen Fasern eine Oberflächenschicht aus mikroporösem Kohlenstoff ≤ 100 nm aufweisen.

7. Verfahren nach einem der Ansprüche 1 bis 6, **dadurch gekennzeichnet, dass** die Fasern mit einer durch die chemische Behandlung nicht entfernbaren Schlichte überzogen sind und dass das Verfahren den vorhergehenden Schritt des nahezu vollständigen Entfernens der Schlichte durch Wärmebehandlung umfasst.

8. Verfahren nach einem der Ansprüche 1 bis 7, **dadurch gekennzeichnet, dass** es den zusätzlichen Schritt des Abscheidens einer Schicht aus pyrolytischem Kohlenstoff auf den behandelten Siliziumkarbidfasern umfasst.

9. Verfahren zur Herstellung eines Faservorformlings, umfassend die Ausbildung einer Faserstruktur auf der Basis von Siliziumkarbidfasern, **dadurch gekennzeichnet, dass** die Fasern entsprechend dem Behandlungsverfahren nach einem der Ansprüche 1 bis 8 behandelt worden sind.

10. Verfahren nach Anspruch 9, **dadurch gekennzeichnet, dass** die Fasern vor der Ausbildung der Faserstruktur behandelt werden.

11. Verfahren nach Anspruch 9, **dadurch gekennzeichnet, dass** die Fasern nach der Ausbildung der Faserstruktur behandelt werden.

12. Verfahren zur Herstellung eines Verbundwerkstoffteils, umfassend die Herstellung eines Faservorformlings entsprechend dem Verfahren nach einem der Ansprüche 9 bis 11 und das Verdichten des Vorformlings.

## Claims

1. A process for the treatment of silicon carbide fibers, comprising the step of chemical treatment of the fibers with an aqueous acid solution containing hydrofluoric acid and nitric acid in order to remove the silica present at the surface of the fibers and to form a layer of microporous carbon, **characterized in that** said aqueous acid solution does not contain acetic acid and **in that** its hydrofluoric acid content is of between 0.5 and 4 mol/l.

2. The process as claimed in claim 1, **characterized in that** the aqueous acid solution contains a hydrofluoric acid/nitric acid molar ratio of less than 1.5, advantageously less than 0.7, in particular greater than 0.1.

3. The process as claimed in either one of claims 1 and 2, **characterized in that** the aqueous acid solution contains a hydrofluoric acid content of between 0.5 and 2 mol/l.

4. The process as claimed in any one of claims 1 to 3, **characterized in that** the aqueous acid solution contains a nitric acid content of between 0.5 and 5 mol/l, advantageously between 2 and 5 mol/l.

5. The process as claimed in any one of claims 1 to 4, **characterized in that** the chemical treatment step is carried out at ambient temperature and lasts four hours.

6. The process as claimed in any one of claims 1 to 5, **characterized in that** the fibers obtained have a superficial layer of microporous carbon ≤100 nm.

7. The process as claimed in any one of claims 1 to 6, **characterized in that** the fibers are covered with a sizing not removable by chemical treatment, and **in that** the process comprises the prior step of virtually completely removing said sizing by heat treatment.

8. The process as claimed in any one of claims 1 to 7, **characterized in that** it comprises the additional step of depositing a layer of pyrolytic carbon on the silicon carbon fibers treated.

9. A process for the production of a fibrous preform comprising the formation of a fibrous structure based on silicon carbide fibers, **characterized in that** the fibers have been treated in accordance with the treatment process as claimed in any one of claims 1 to 8.

10. The process as claimed in claim 9, **characterized in that** the fibers are treated before the formation of the fibrous structure.

11. The process as claimed in claim 9, **characterized in that** the fibers are treated after the formation of the fibrous structure.

12. A process for the production of a part made from composite material, comprising the production of a fibrous preform in accordance with the process as claimed in any one of claims 9 to 11 and the densification of said preform.
